(19) Europäisches Patentamt

European Patent Office

Office européen des brevets

(11) **EP 1 052 521 B1**

(12) **EUROPEAN PATENT SPECIFICATION**

(45) Date of publication and mention
of the grant of the patent:
**20.10.2004  Bulletin 2004/43**

(51) Int Cl.⁷: **G01R 33/46**

(21) Application number: **99108737.0**

(22) Date of filing: **03.05.1999**

(54) **Compensation of radiation damping during selective pulses in NMR spectroscopy**

Kompensation von Strahlungsdämpfung während selektiver Pulse in der
Kernspinresonanzspektroskopie

Compensation de l'amortissement de radiation pendant des impulsions sélectives dans la
spectroscopie à RMN

(84) Designated Contracting States:
**CH DE FR GB LI**

(43) Date of publication of application:
**15.11.2000  Bulletin 2000/46**

(73) Proprietor: **Bruker BioSpin AG**
**8117 Fällanden (CH)**

(72) Inventors:
• **Chen, Jin Hong, Dr.**
**Cambridge, MA 02141 (US)**
• **Jerschow, Alexej, Dr.**
**Albany, CA 94706 (US)**

• **Bodenhausen, Geoffrey, Prof.**
**F-75014 Paris (FR)**

(74) Representative: **KOHLER SCHMID + PARTNER**
**Patentanwälte**
**Ruppmannstrasse 27**
**70565 Stuttgart (DE)**

(56) References cited:
• **W.S.WARREN ET AL.: "Dynamics of radiation**
**damping in nuclear magnetic resonance"**
**J.CHEM.PHYS., vol. 91, no. 10, 1989, pages**
**5895-5904, XP002116030**

**Description**

The invention refers to a method for compensating radiation damping (=RD) effects during selective or non-selective radio frequency (=rf) pulses in nuclear magnetic resonance (=NMR) spectroscopy.

A wide variety of amplitude or phase modulated pulses, which are designed for selective excitation, inversion or refocusing, are severely perturbed by radiation damping effects in the presence of a large macroscopic magnetisation.

It is an object of the invention to present a general method to compensate for radiation damping during the application of selective rf pulses. This method, which has general applicability for any amplitude or frequency modulated rf pulse, is demonstrated experimentally for inversion pulses.

It is well known that a strong macroscopic magnetisation, such as due to a solvent at high magnetic fields, leads to rather peculiar features in NMR experiments. These effects come generally in two flavours: radiation damping (RD), described in 1954 by Bloembergen and Pound [1], and effects of the dipolar demagnetising field (DDF), discovered in 1979 [2]. RD produces a back-action field which tends to rotate the magnetisation back to its equilibrium position. Feedback devices have been proposed to compensate for RD effects [3, 4], and the application of a DANTE pulse sequence during acquisition can be effective in compensating RD [5].

An extensive variety of amplitude or phase modulated pulses have been designed to selectively excite, invert, or refocus magnetisation. Ideally these pulses should be able to act uniformly on a specific spectral region while leaving the rest of the spectrum untouched. However, as soon as transverse magnetisation is created, RD sets in and leads to the appearance of an additional rf field, which is proportional to the transverse magnetisation but lags 90° in phase. The magnetisation is affected by two fields, the sum of which can significantly differ from the original shaped pulse. Severe distortions of excitation profiles are expected when the RD field has an amplitude comparable in strength to the rf pulse. In particular, selective inversion of strong solvent signals is known to be problematic [6]. We have likewise encountered difficulties in applying synchronous nutation [7,8] and QUIET methods [9] under conditions where RD is pronounced.

The present invention shows a general method to render arbitrarily shaped selective pulses immune to RD effects. This objective is similar to the pursuit of Warren, Hammer, and Bates [10], who adapted shaped pulses to remove complications generated by RD. For example, in the absence of RD a hyperbolic secant pulse leads to an efficient inversion, but the profile is disturbed by RD. By adjusting the real and imaginary components of the selective pulse by numerical methods, it is possible to restore a nearly ideal response. This optimisation must be repeated for different RD time constants and for different offsets.

In the approach according to the present invention, we do not adjust the shape of the selective pulse by numerical optimisation but calculate the corrections required for any offset from the knowledge of the RD time constant and of the ideal trajectory of the magnetisation in the course of the selective pulse. Our procedure allows one to create compensated rf pulse shapes starting from existing (optimised) pulse shapes [11, 12] without using complicated optimisation techniques.

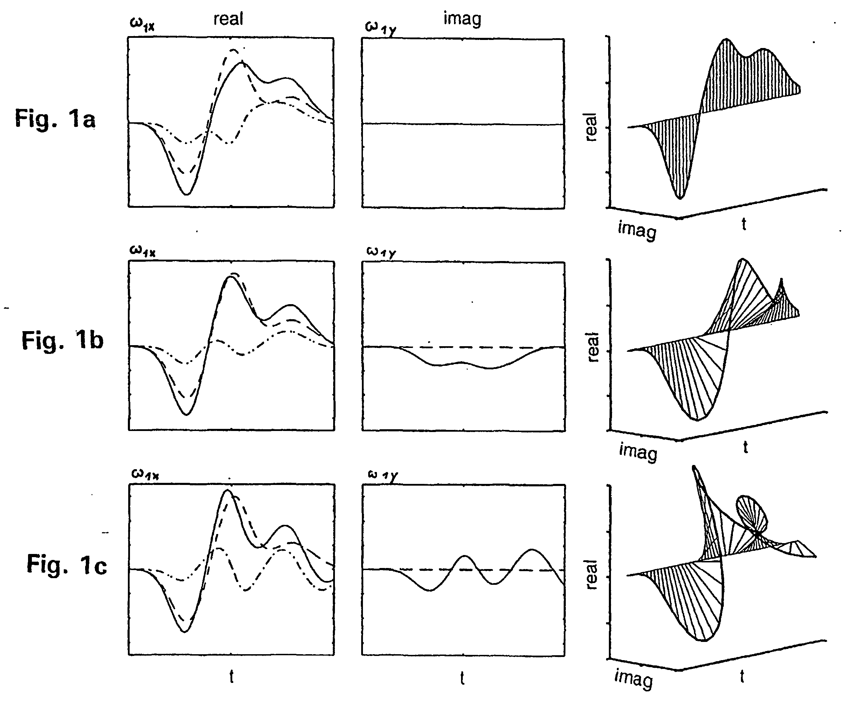

Figures 1a-1c illustrate the procedure: The complex reaction field, $\omega_+^{rd} = \omega_x^{rd} + i\omega_y^{rd}$, is proportional to but shifted in phase with respect to the transverse magnetisation $M_+ = M_x + i\,M_y$ (normalised by the equilibrium magnetisation $M_0$) according to:

$$\omega_+^{rd}(t) = -\,i\,R_{rd}\,M_+(t) \tag{1}$$

The time dependence of $M_+(t)$ during the selective pulse arises from a combination of nutation, precession, and possibly relaxation. If we assume that the shaped rf pulse works properly, we can calculate the expected transverse magnetisation $M_+(t)$ by solving the Bloch equations. The RD rate (in rad s$^{-1}$) is defined by:

$$R_{rd} = 1/T_{rd} = 2\,\pi\,\gamma\,\eta\,Q\,M_0 \tag{2}$$

where $\eta$ is the filling factor and $Q$ the quality factor of the receiver coil. The complex amplitude of the compensated rf pulse is given by:

$$\omega_+^{comp}(t) = \omega_+^{unc}(t) + \omega_+^{corr}(t) \tag{3}$$

where $\omega_+^{unc}(t)$ is the ordinary uncompensated shape of the selective pulse, and where

$$\omega_+{}^{corr}(t) = -\omega_+{}^{rd}(t) = i\, R_{rd}\, M_+(t). \tag{4}$$

The factor $R_{rd} = 1/T_{rd}$ can be adjusted empirically. For amplitude modulated selective pulses, $\omega_+{}^{unc}(t)$ appears static in a frame rotating with the carrier frequency $\omega_{rf}$, while $\omega_+{}^{rd}(t)$ rotates at an offset $\Delta\omega = \omega_0 - \omega_{rf}$ where $\omega_0$ is the Larmor frequency of the strong (solvent) resonance.

The following experimental procedure can be recommended to optimise RD compensation for an arbitrary frequency or phase modulated pulse:

1) Choose a suitable shaped pulse and calculate $M_+(t)$ numerically by solving the Bloch equations on resonance, assuming that there is no RD.

2) Calibrate the rf amplitude on-resonance on a sample with little RD (e. g., residual $H_2O$ in 99.5 % $D_2O$).

3) Estimate $R_{rd} = 1/T_{rd}$ in Eq. (4) empirically on a sample with RD (e. g., 90 % $H_2O$ with 10 % $D_2O$ for field-frequency locking). If $R_{rd}$ is estimated correctly, good inversion should be achieved on-resonance.

3a) Create compensated shapes for each required offset $\Delta\omega$ and acquire an offset profile using the sequence [selective pulse] - [pulsed field gradient] - [non-selective excitation $\beta = 90°$] - [acquisition]. Note that for every offset the compensated pulse shape must be calculated separately.

4) Adjust the estimate of $R_{rd}$ in Eq.(4) and repeat steps 3 and 3a until an optimal offset profile is obtained.

Usually steps 2) and 3) are sufficient to obtain a fairly good profile but improvement can still be achieved by repeating steps 3) and 3a), especially when the RD field strength is high compared to the rf pulse amplitude. This represents also a very accurate method to determine $R_{rd}$, which is difficult with other techniques.

Using a Bruker Avance 600 MHz spectrometer, the pulse amplitude of a $G^3$ Gaussian cascade [12] was calibrated for ideal inversion on-resonance with a sample consisting of 0.5% $H_2O$ and 99.5% $D_2O$ (sample I). The RD correction of Eq.(4) was then adjusted empirically on 90% $H_2O$ with 10% $D_2O$ (sample II) by creating corrected rf pulse shapes with increasing trial values of $R_{rd}$ until good inversion was achieved on-resonance, i.e., by minimisation of the signal after a sequence $G^3$- $1800°_{n.sel}$ - acquisition. The nonselective 180° pulse was inserted to avoid superradiant effects associated with the unstable state of inverted magnetisation. We then repeated steps 3) and 3a) twice to achieve best results.

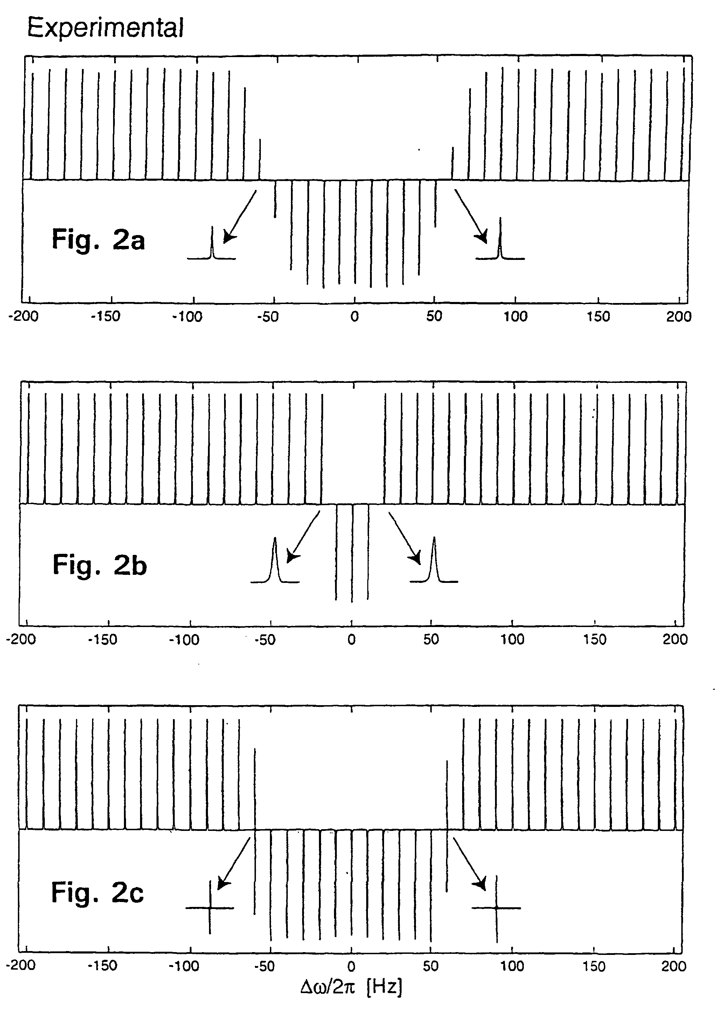

Figures 2a-2c show profiles as a function of offset: (a) for sample I with a normal $G^3$ pulse shape, (b) for sample II with a normal $G^3$ pulse shape, and (c) for sample II with a compensated $G^3$ pulse shape. Almost perfect band inversion is achieved with the compensated pulse. Note that RD is still present during acquisition in (b) and (c). The experiments in Fig. 2c yield significantly better 'top-hat' inversion than in Fig. 2a. This surprising improvement is due to a lineshape effect induced by RD, as evidenced in the inserts. The integral over the lineshapes is not affected by RD, since the initial magnitude of the transverse magnetisation is not modified [13, 14].

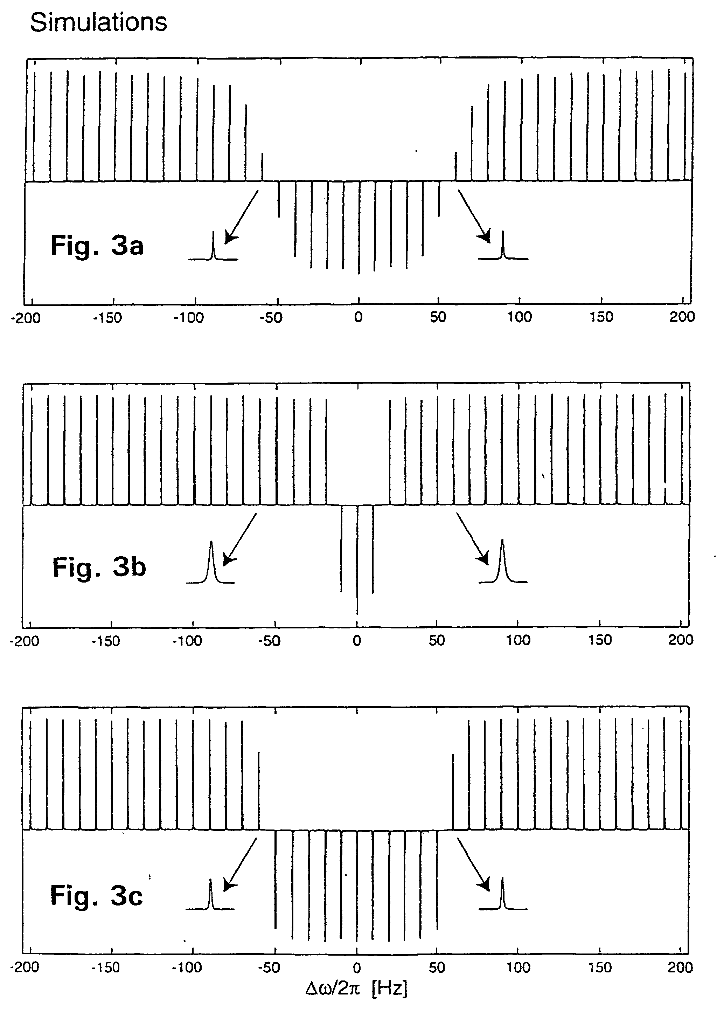

Figures 3a-3c show simulations corresponding to the experiments in Figures 2a-2c including relaxation. Radiation damping was included in the simulations both during the selective pulse and during acquisition in (b), but only during acquisition in (c). For sample I: $T_1 = 11.5$ s, $T_{rd} = $ , $T_2^* = 0.12$ s; for sample II: $T_1 = 2.4$ s, $T_{rd} = 6.37$ ms, $T_2^* = 0.12$ s.

In conclusion, the present invention shows that the effects of RD during selective irradiation can be eliminated by modifying the rf pulse shapes. In our case the peak amplitude of the RD field is comparable to the peak amplitude of the shaped pulse. Applications to selective excitation pulses, to selective cross-polarisation [15], to NOE studies, and to synchronous nutation [7, 8] are possible.

**Figure Captions**

**Figures 1a-1c:**

Uncompensated $G^3$ inversion pulse cascade $\omega_+{}^{unc}(t)$ (dashed lines), negative radiation damping (RD) field $\omega_+{}^{corr}(t) = -\omega_+{}^{rd}(t) = i\, R_{rd}\, M_+(t)$ calculated from the Bloch equations with an RD time constant $T_{rd} = 1/R_{rd} = 6.37$ ms (dash-dotted lines), and compensated pulse shapes $\omega_+{}^{comp}(t)$ (solid lines) for a pulse of 40 ms overall duration. The offsets $\Delta\omega = \omega_0 - \omega_{rf}$ between the Larmor frequency $\omega_0$ and the rf carrier frequency $\omega_{rf}$ are (a) $\Delta\omega/2\pi = 0$ (on-resonance), (b) $\Delta\omega/2\pi = 30$ Hz, (c) $\Delta\omega/2\pi = 60$ Hz. The real and imaginary parts $\omega_{1x}$ and $\omega_{1y}$ are shown separately, as well as three-dimensional views of the compensated pulses.

**Figures 2a-2c:**

The results of the following experiment are shown as a function of offset $\Delta\omega/2\pi$. $180°_{sel}$ - pfg - $90°_{n.sel}$ - acq, where $180°_{sel}$ stands for selective inversion pulses of 40 ms duration, pfg is a sine-shaped pulsed field gradient of 1.5 ms duration and 0.2 T/m peak strength. (a) 0.5% $H_2O$ with 99.5% $D_2O$ (sample I), (b) 90% $H_2O$ with 10% $D_2O$ (sample II), both using uncompensated $G^3$ shapes for $180°_{sel}$, (c) sample II using a $G^3$ shape corrected for RD as explained in the text. The lineshapes can be appreciated in the inserts which have been expanded horizontally $10\times$ in (a) and $5\times$ in (b) and (c), and scaled vertically $1\times$ in (a) and $0.4\times$ in (b) and (c)

**Figures 3a-3c:**

Simulated offset profiles corresponding to the experiments in Figures 2a-2c including relaxation. For sample I: $T_1$ = 11.5 s, $T_{rd}$ = , $T_2^*$ = 0.12 s; for sample II: $T_1$ = 2.4 s, $T_{rd}$ = 6.37 ms, $T_2^*$ = 0.12 s. (a) No RD considered. (b) RD was included in the simulation during both soft pulse and acquisition. (c) RD active during acquisition only, since it is compensated during the soft pulse. The inserts have been enlarged as in Figures 2a-2c.

**References**

[1] N. Bloembergen, R. V. Pound, Phys. Rev. **95** (1954) 8.
[2] G. Deville, M. Bernier, J. M. Delrieux, Phys. Rev. B **19** (1979) 5666.
[3] P. Broekaert, J. Jeener, J. Magn. Reson. A **113** (1995) 60.
[4] A. Louis-Joseph, D. Abergel, J. Lallemand, J. Biomol. NMR **5** (1995) 212.
[5] H. Barjat, D. L. Mattiello, R. Freeman, J. Magn. Reson. **136** (1999) 114.
[6] G. Otting, Prog. Nucl. Magn. Reson. Spectrosc. **32** (1998) 259.
[7] R. Konrat, I. Burghardt, G. Bodenhausen, J. Am. Chem. Soc. **114** (1992)10679
[8] I. Burghardt, R. Konrat, B. Boulat, S. J. F. Vincent, G. Bodenhausen, J. Chem. Phys. **98** (1993) 1721.
[9] C. Zwahlen, S. J. F. Vincent, L. Di Bari, M. H. Levitt, G. Bodenhausen, J. Am. Chem. Soc. **116** (1994) 362.
[10] W. S. Warren, S. L. Hammes, J. L. Bates, J. Chem. Phys. **91** (1989) 5895.
[11] H. Geen, S. Wimperis, and R. Freeman, J. Magn. Reson. **85** (1989) 620.
[12] L. Emsley and G. Bodenhausen, Chem. Phys. Lett. **165** (1989) 469.
[13] X.-A. Mao, J.-X. Guo, C.-H. Ye, Phys. Rev. B **49** (1994) 15702.
[14] X. -A. Mao, C. -H. Ye, J. Chem. Phys. **99** (1993) 7455.
[15] E. Chiarparin, P. Pelupessy, and G. Bodenhausen, Mol. Phys. **95** (1998) 759.

**Claims**

1. A method for compensating radiation damping (=RD) effects during selective or non-selective radio frequency (=rf) pulses in nuclear magnetic resonance (=NMR) spectroscopy comprising the following steps:

   1) Choose an rf pulse suitably shaped for a selective or non-selective excitation, inversion or refocussing experiment and calculate the expected transverse magnetisation

$$M_+(t) = M_x(t) + i\,M_y(t),$$

   where $i = \sqrt{-1}$ by solving the Bloch equations on-resonance, assuming that there is no RD;

   2) Calibrate the rf amplitude on-resonance on a sample with little RD;

   3) Estimate the RD rate

$$R_{rd} = i/T_{rd} = 2\pi\gamma\eta QM_0,$$

   for a sample with RD,

where $\gamma$ is the gyromagnetic ratio, $\eta$ is the filling factor, Q is the quality factor and $M_0$ is the equilibrium magnetisation;

4) Define a compensated rf pulse shape using the estimate of step 3), given by

$$\omega_+^{comp}(t) = \omega_+^{unc}(t) + \omega_+^{corr}(t) = \omega_+^{unc}(t) + i\,R_{rd}\,M_+(t),$$

where $i = \sqrt{-1}$, $\omega_+^{unc}(t)$ is the ordinary uncompensated shape of the selective or non-selective rf pulse and $M_+(t)$ is the time dependent transverse magnetisation;

5) Record the on-resonance response for the said selective or non-selective excitation, inversion or refocussing experiment.

2. The method according to claim 1, **characterised by** repeating steps 3), 4) and 5) several times.

3. The method according to claim 1 or 2, **characterised by** performing the following step 4a) after step 4):

4a) Create compensated shapes for each required offset $\Delta\omega$ and acquire an offset profile, whereby for every offset the compensated pulse shape is calculated separately.

4. The method according to any one of the preceding claims, **characterised by** using residual $H_2O$ in 99.5% $D_2O$ as a sample with weak RD for the calibration in step 2).

5. The method according to any one of the preceding claims, **characterised by** using 90% $H_2O$ with 10% $D_2O$ for field locking as a sample with RD for estimating $R_{rd}$ in step 3).

## Patentansprüche

1. Verfahren zum Kompensieren von Strahlungsdämpfungseffekten (RD) während selektiver oder nicht selektiver Hochfrequenz (HF) Pulse bei der Kernspinresonanz (NMR) Spektroskopie, das folgende Schritte aufweist:

1) Wählen eines HF-Pulses mit geeigneter Form für ein selektives oder nicht selektives Anregungs-, Inversions- oder Refokussier-Experiment und Berechnen der erwarteten Quermagnetisierung

$$M_+(t) = M_x(t) + iM_y(t),$$

wobei $i = \sqrt{-1}$
durch Lösen der Bloch-Gleichungen bei Resonanz unter der Annahme, dass keine RD existiert;

2) Kalibrieren der HF-Amplitude bei Resonanz an einer Probe mit geringer RD,

3) Schätzen der RD-Rate

$$R_{rd} = i\,/\,T_{rd} = 2\pi\gamma\eta\,QM_0$$

für eine Probe mit RD,
wobei $\gamma$ das gyromagnetische Verhältnis, $\eta$ der Füllfaktor, Q der Qualitätsfaktor und $M_0$ die Gleichgewichtsmagnetisierung sind;

4) Definieren einer kompensierten HF-Pulsform mittels der Schätzung von Schritt 3), gegeben durch

$$\omega_+^{comp}(t) = \omega_+^{unc}(t) + \omega_+^{corr}(t) = \omega_+^{unc}(t) + i\,R_{rd}\,M_+(t),$$

wobei i= $\sqrt{-1}$, $\omega_+^{unc}(t)$ die normale, nicht kompensierte Form des selektiven oder nicht selektiven HF-Pulses und $M_+(t)$ die zeitabhängige Quermagnetisierung sind;

5) Aufzeichnen der Antwort bei Resonanz für das selektive oder nicht selektive Anregungs-, Inversions- oder Refokussier-Experiment.

**2.** Verfahren nach Anspruch 1, **gekennzeichnet durch** mehrmaliges Wiederholen der Schritte 3), 4) und 5).

**3.** Verfahren nach Anspruch 1 oder 2, **gekennzeichnet durch** Ausführen des folgenden Schritts 4a) nach Schritt 4):

4a) Erzeugen von kompensierten Formen für jeden erforderlichen Offset $\Delta\omega$ und Erfassen eines Offsetprofils, wodurch für jeden Offset die kompensierte Pulsform separat berechnet wird.

**4.** Verfahren nach einem der vorhergehenden Ansprüche, **gekennzeichnet durch** Verwendung von restlichem $H_2O$ in 99.5% $D_2O$ als Probe mit schwacher RD für die Kalibrierung in Schritt 2).

**5.** Verfahren nach einem der vorhergehenden Ansprüche, **gekennzeichnet durch** Verwendung von 90% $H_2O$ mit 10% $D_2O$ für Feld-Locking als Probe mit RD zum Schätzen von $R_{rd}$ in Schritt 3).

## Revendications

**1.** Procédé de compensation des effets de l'amortissement de radiation (= RD) pendant des impulsions de radiofréquence (= rf) sélectives et non sélectives dans la spectroscopie à résonance magnétique nucléaire (= NMR) comprenant les étapes suivantes :

1) le choix d'une impulsion rf formée de façon appropriée pour une expérience d'excitation, d'inversion ou de refocalisation sélective ou non sélective et le calcul de la magnétisation transversale attendue

$$M_+(t) = M_x(t) + iM_y(t),$$

où i = $\sqrt{-1}$
en résolvant les équations de Bloch sur résonance, en admettant qu'il n'existe pas de RD ;
2) la calibration de l'amplitude de la rf sur résonance sur un échantillon avec un faible RD ;
3) l'estimation de la vitesse du RD

$$R_{rd} = 1/T_{rd} = 2\pi\gamma\eta QM_0,$$

pour un échantillon avec RD,
où $\gamma$ représente le rapport gyromagnétique, $\eta$ représente le facteur de remplissage, Q représente le facteur de qualité et $M_0$ représente la magnétisation d'équilibre ;
4) la définition d'une forme d'impulsion de la rf compensée en utilisant l'estimation de l'étape 3), donnée par

$$\omega_+^{comp}(t) = \omega_+^{déc}(t) + \omega_+^{corr}(t) = \omega_+^{déc}(t) + iR_{rd}M_+(t),$$

où i = $\sqrt{-1}$, $\omega_+^{déc}(t)$ représente la forme non compensée ou décompensée ordinaire de l'impulsion de la rf sélective ou non sélective et $M_+(t)$ représente la magnétisation transversale dépendante du temps ;
5) l'enregistrement de la réponse sur résonance pour ladite expérience d'excitation, d'inversion ou de refocalisation sélective ou non sélective.

**2.** Procédé selon la revendication 1, **caractérisé en ce que** les étapes 3), 4) et 5) sont répétées plusieurs fois.

**3.** Procédé selon les revendications 1 ou 2, **caractérisé en ce que** l'étape suivante 4a) est réalisée après l'étape 4) :

4a) la création de formes compensées pour chaque décalage $\Delta\omega$ requis et l'acquisition d'un profil de décalage, moyennant quoi pour chaque décalage la forme d'impulsion compensée est calculée séparément.

4. Procédé selon l'une quelconque des revendications précédentes, **caractérisé en ce que** du $H_2O$ résiduel est utilisé dans du $D_2O$ à 99,5 % comme un échantillon avec un faible RD pour la calibration de l'étape 2).

5. Procédé selon l'une quelconque des revendications précédentes, **caractérisé en ce que** du $H_2O$ à 90 % est utilisé dans du $D_2O$ à 10 % pour verrouiller le champ comme un échantillon avec RD pour estimer $R_{rd}$ dans l'étape 3).

**Fig. 1a**

**Fig. 1b**

**Fig. 1c**

Experimental

Fig. 2a

Fig. 2b

Fig. 2c

$\Delta\omega/2\pi$ [Hz]

Simulations

Fig. 3a

Fig. 3b

Fig. 3c

$\Delta\omega/2\pi$ [Hz]